Europäisches Patentamt

European Patent Office

Office européen des brevets

(19)

(11) Publication number: **0 069 493**
A2

(12) **EUROPEAN PATENT APPLICATION**

(21) Application number: 82303185.1

(22) Date of filing: 18.06.82

(51) Int. Cl.³: **G 11 C 17/00**

(30) Priority: 30.06.81 JP 102872/81

(43) Date of publication of application:
12.01.83 Bulletin 83/2

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Shirato, Takehide
FUJITSU LIMITED, Patent Dept. 1015 Kamikodanaka
Nakahara-ku Kawasaki-shi Kanagawa 211(JP)

(74) Representative: Sunderland, James Harry et al,
HASELTINE LAKE & CO Hazlitt House 28 Southampton
Buildings Chancery Lane
London WC2A 1AT(GB)

(54) Mask read only memory.

(57) A read only memory has memory cells each comprising a transistor (e.g. Tr1), connected to a word line ($W_i$), which is either an offset gate transistor or an enhancement transistor in accordance with data set in the memory cell.

The transistor (Tr1) of one memory cell and the transistor (Tr2) of an adjacent memory cell have a common drain region commonly connected to a bit line ($B_i$).

FIG. 3A

-1-

## "MASK READ ONLY MEMORY"

This invention relates to a mask ROM (read only memory).

A mask ROM allows the entry and storage therein of data designated or selected by the intended user of the ROM, in accordance with the user's requirements.

Generally speaking a system is employed in which the user designated data is entered into the ROM in the course of manufacture of the ROM.

It is desirable that user designated data can be entered into such a ROM at as late a stage as possible in the manufacture of the ROM. This is desirable because the later is the stage at which data is entered the shorter can be the period (the lead time) between a user ordering a ROM and delivery of the ROM, with the user designated data, to the user.

-2-

Previously, the provision of the ability to allow user designated data to be entered at a late manufacturing stage has involved the use of a ROM structure offering only a relatively low integration density.

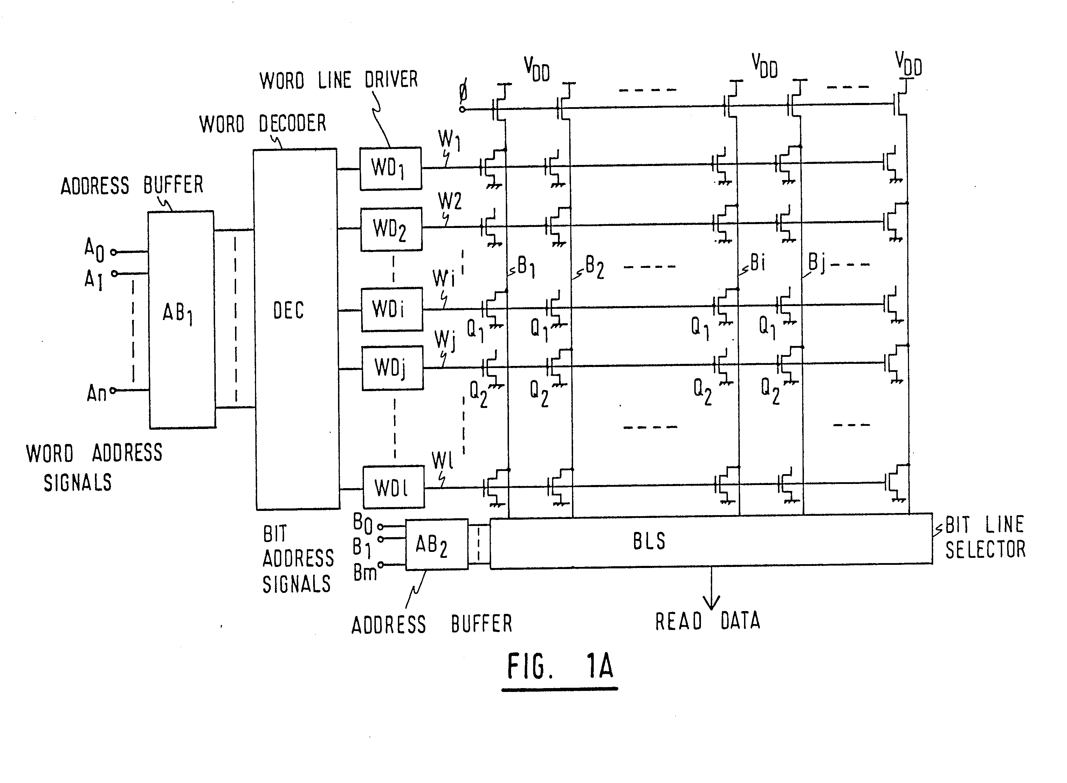

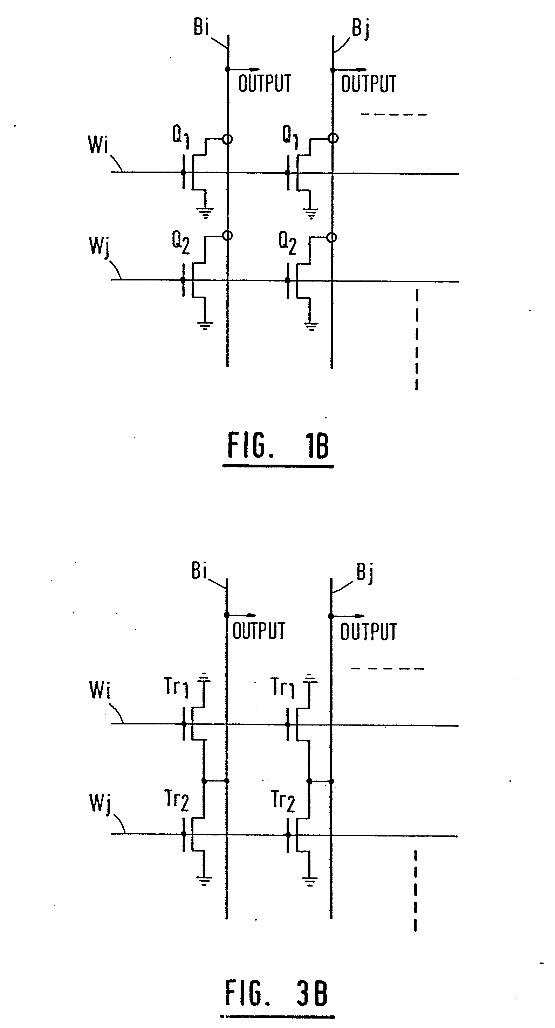

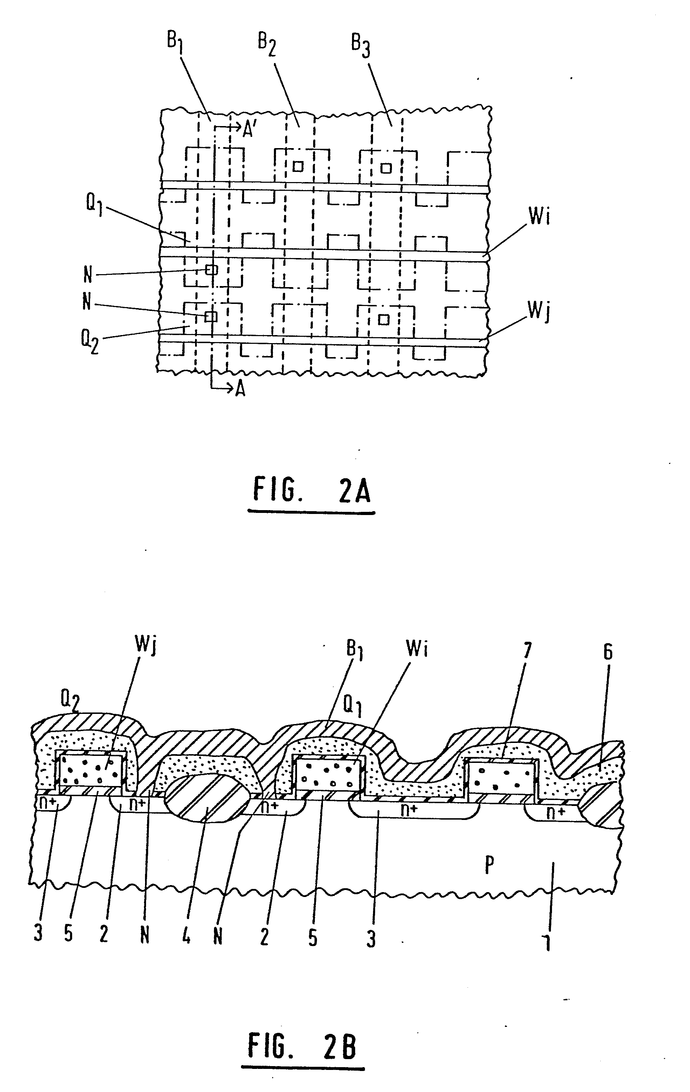

Figures 1A and 1B, and Figures 2A and 2B, of the accompanying drawings illustrate the structure of a previously proposed mask ROM in which user designated data is entered in terms of the existence or non-existence of electrode contact windows.

Figure 1A is a schematic block diagram of a previously proposed ROM, Figure 1B shows a detail of a ROM of the form illustrated in Figure 1A, Figure 2A is a partial plan view of a ROM of the form illustrated in Figure 1A, and Figure 2B is a sectional view taken along the line A-A' of Figure 2A.

In Figure 1A, an address buffer $AB_1$ is arranged for receiving word address signals $A_0$ to $A_n$ and for changing the levels of the word address signals. A word decoder DEC receives output signals of the address buffer $AB_1$ and is operable to select one word line driver $WD_1$, $WD_2$.. $WD_i$, $WD_j$... $WD_l$ in accordance with the output signals of the address buffer $AB_1$. The word line drivers $WD_1$ to $WD_l$ are connected to respective word lines $W_1$ to $W_l$. Each line driver is operable, when selected, to bring the connected word line to a high level.

An address buffer $AB_2$ is arranged for receiving bit address signals $B_0$ to $B_n$ and for changing the levels of the bit address signals. A bit line selector BLS receives output signals of the address buffer $AB_2$ and delivers output data (READ DATA) from the bit lines as designated by the bit address signals $B_0$ to $B_n$.

$\phi$ is a signal for precharging the bit lines during a standby period and $V_{DD}$ is a power supply voltage.

The mask ROM of Figure 1A can be regarded as comprising a plurality of memory cells each comprising an enhancement type MOS transistor, e.g. $Q_1$ (or $Q_2$), whose gate electrode is connected to one word line, for example word line $W_i$ in Figure 1A. The source of the transistor is grounded whilst the drain is connected or not connected to a common bit line, e.g. $B_i$, depending upon the presence or absence of an electrode contact window through which contact can be established between drain and bit line. In Figure 1A connection and non-connection of drains and bit lines are indicated schematically. Electrode contact windows are not shown.

In Figure 1A, in the memory cells at the intersection of word lines $W_i$ and $W_j$ with the bit line $B_i$, transistor $Q_1$ has its drain connected to the bit line $B_i$ whilst the drain of transistor $Q_2$ is not connected. In the memory cells at the intersection of $W_i$ and $W_j$ with bit line $B_j$, the drain of transistor $Q_1$ is not connected to $B_j$ whilst the drain of $Q_2$ is connected.

In the detailed view of Figure 1B, small open circles schematically indicate locations at which electrode contact windows can be provided for the drains of transistors of the memory cells at the intersections of word lines $W_i$, $W_j$ with bit lines $B_i$ and $B_j$.

Connection between the drain of the transistor of a memory cell and the relevant bit line is, as mentioned

-4-

above, established or not established in dependence upon the existence of an appropriate electrode contact window.

The plan view of Figure 2A illustrates an example of the provision of electrode contact windows N for establishing connections in relation to word lines $W_i$ and $W_j$ and bit lines $B_1$, $B_2$ and $B_3$. It should be noted that the connections shown as established in Figure 2A do not correspond to those shown in Figure 1A.

Figure 2B is a cross-sectional view, taken along the line A-A' in Figure 2A, illustrating layer structure in the mask ROM and the location of contact windows N in that structure.

In Figure 2B, 1 is a p-type substrate, 2 and 3 are drain and source regions respectively, 4 is a field oxide layer of $SiO_2$, 5 indicates gate oxide layers of $SiO_2$, $W_i$ and $W_j$ are word lines of polycrystalline silicon, 6 is an insulating layer of phosphosilicate glass, $B_1$ is a bit line of aluminium, and 7 is a thin oxide layer of $SiO_2$.

An electrode contact window N, where provided, is established through the phosphosilicate glass layer 6 and the thin oxide layer 7 of $SiO_2$ to permit connection of the bit line to drain region 2 of a transistor of a memory cell.

In Figure 2B contact windows N are shown which provide connection of the drains of both transistors $Q_1$ and $Q_2$ of the memory cells at the intersections of word lines $W_i$ and $W_j$ with a bit line $B_1$.

To read user designated data, set in the memory cells of such a previously proposed ROM in terms of the existence or non-existence of electrode contact windows, a selected word line e.g. $W_i$ , is set at a high ("H") level, whilst non-selected word lines are set at a low ("L") level. Where an electrode contact window exists which connects the drain portion of a transistor $Q_1$ of such a memory cell to a selected bit line (the gate electrode of transistor $Q_1$ being connected to the selected word line $W_i$ ) the transistor $Q_1$ becomes conductive and allows current to flow to ground. Thus, the potential of the bit line is brought to a low "L" level. Where such an electrode contact window does not exist the transistor $Q_1$ cannot allow current to flow to ground and the potential of the bit line remains at "H" level.

Although the previously proposed ROM allows user designated data to be set therein the integration density provided by the ROM is low. The drain portions of the transistors $Q_1$, $Q_2$ of memory cells of the previously proposed ROM have independent pattern structures, and the pattern area required for forming such an arrangement is relatively large (e.g. $28\mu$ x 9 $\mu$) and consequently integration density is relatively low.

According to the present invention there is provided a read only memory, comprising:-
    a plurality of bit lines,
    a plurality of word lines, and
    a plurality of memory cells, each comprising a transistor connected to a respective one of the plurality of word lines and arranged for establishing a read output level, in accordance with data set in the memory cell, on a respective one of the bit lines,
        characterised in that the said transistor of a memory cell is either an offset gate transistor or an enhancement transistor, in accordance with data set in the memory cell, and the said transistor is connected to the respective one of the bit lines together with a transistor of an adjacent memory cell via common connection means.

A ROM embodying the present invention allows the entry of user designated data and can provide a higher integration density for the memory pattern of the ROM.

Reference is made, by way of example, to the accompanying drawings, in which:-

Figure 1A is a schematic block diagram of a previously proposed mask ROM,

Figure 1B shows schematically a detail of a previously proposed mask ROM,

Figure 2A is a partial plan view of a previously proposed mask ROM,

Figure 2B is a sectional view taken along line A-A' in Figure 2A,

Figure 3A is a schematic block diagram of a ROM embodying the present invention,

Figure 3B shows schematically a detail of the ROM of Figure 3A,

Figure 4A is a partial plan view of the ROM of Figure 3A,

Figure 4B is a plan view corresponding to the detail of Figure 3B,

Figure 4C is a sectional view taken along the line B-B' of Figure 4A, and

Figure 4D is a simplified sectional view taken in the plan view of Figure 4B.

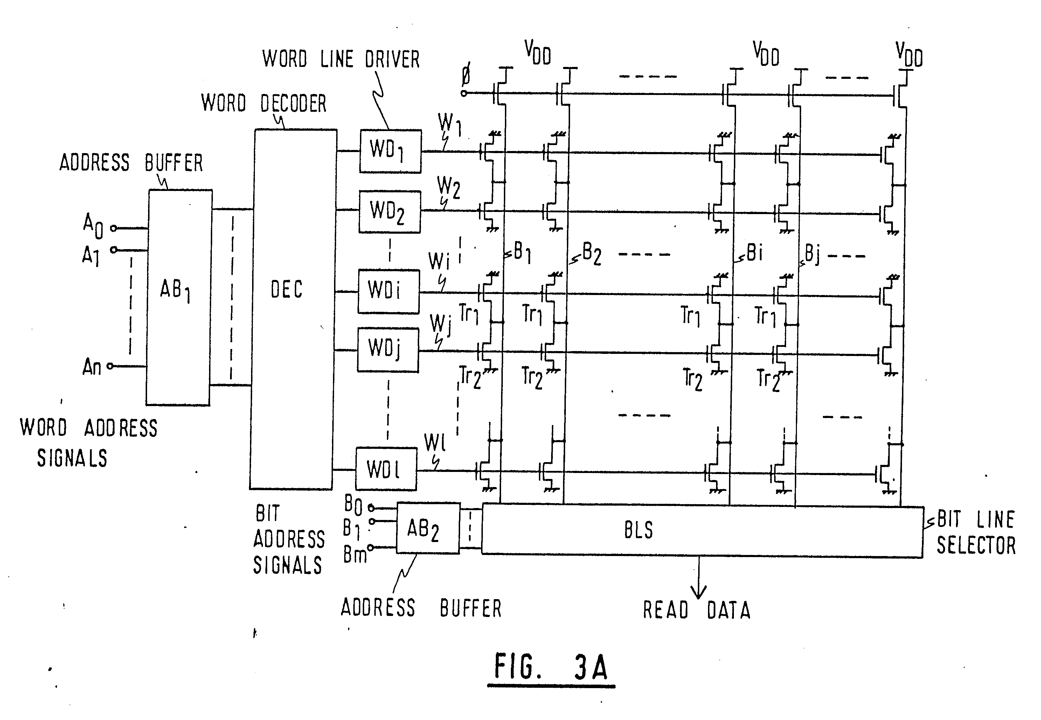

In Figures 3A and 3B, parts corresponding to those shown in Figures 1A and 1B are labelled similarly.

-7-

The mask ROM of Figure 3A can be regarded as comprising a plurality of memory cells each constituted by an MOS transistor, Tr1 or Tr2. The gate electrode of one transistor (Tr1) is connected to one word line, e.g. $W_i$, whilst the gate electrode of the other transistor (Tr2) is connected to the adjacent word line, e.g. $W_j$. The sources of the transistors Tr1 and Tr2 are grounded. The transistors Tr1 and Tr2 have a common drain portion. The common drain portion is connected to a bit line, e.g. $B_i$, by way of an electrode contact window.

When a memory cell is to contain data such that a bit line (e.g. $B_i$) is to be set to high ("H") level when a word line (e.g. $W_i$) connected to the gate electrode of the transistor (e.g. Tr1) of the cell is selected, the transistor Tr1 of the appropriate memory cell is formed as an offset gate transistor.

On the other hand, when a memory cell is to contain data such that the bit line $B_i$ is to be set to low ("L") level when the word line $W_i$ connected to the gate electrode of transistor (e.g. Tr1) of the cell is selected, the transistor Tr1 is formed as an enhancement type transistor.

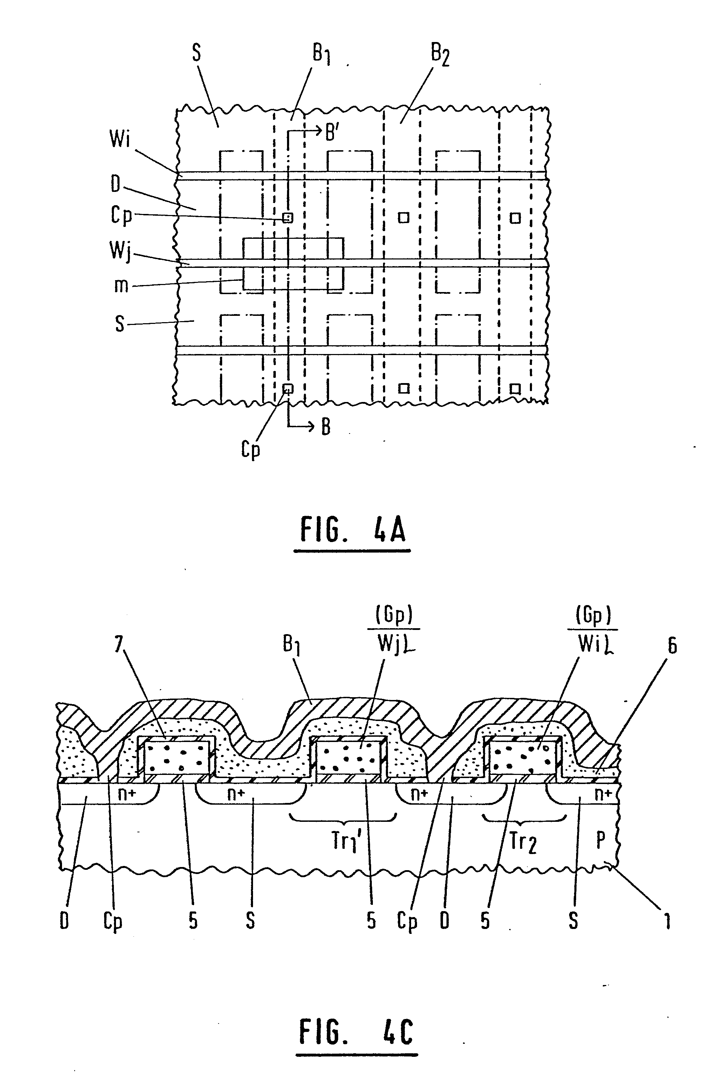

Figure 4A is a plan view illustrating in part the layout of the ROM of Figure 3A. In Figure 4A, $W_i$, $W_j$, $B_1$, $B_2$ correspond to items similarly labelled in Figure 3A. S indicates source regions, D indicates the common drain region of two transistors Tr1, Tr2, and Cp indicates an electrode contact window for establishing connection between a common drain region and a bit line.

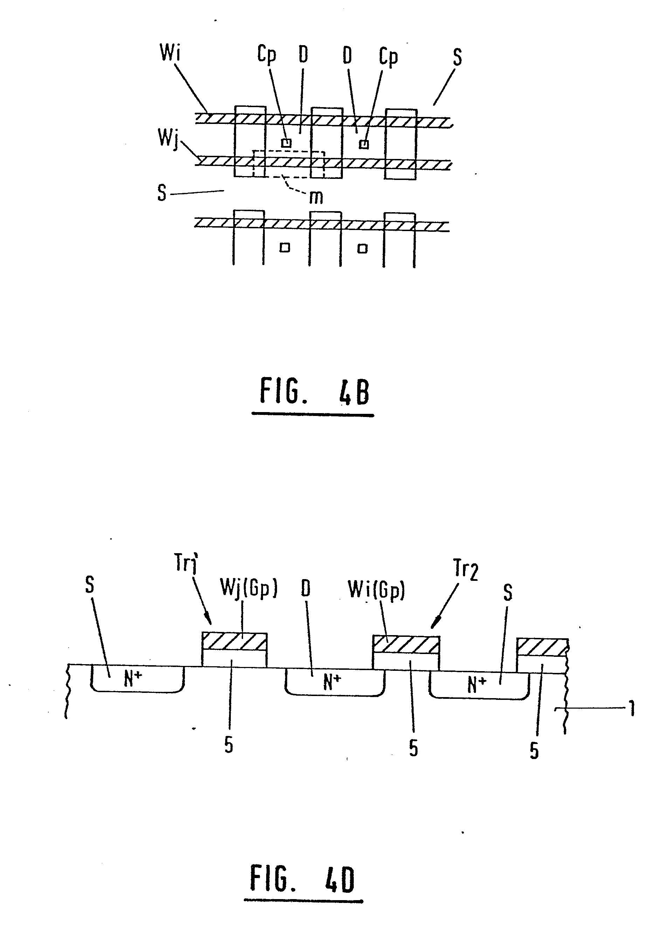

Similarly, Figure 4B is a plan view corresponding to the detail of Figure 3B, although bit lines are not shown in Figure 4B.

Figure 4C is a sectional view taken along the line B-B' in Figure 4A.

In Figure 4C, 1 is a p-type substrate, S and D are source and drain regions respectively, 5 indicates gate oxide layers of $SiO_2$, 6 is an insulating layer of phosphosilicate glass , and 7 is a thin oxide layer of $SiO_2$ . In Figure 4C, transistor gates (Gp) which are parts of word lines $W_i$, $W_j$ are formed of polycrystalline silicon whilst bit line $B_i$ is of aluminium. Cp indicates electrode contact windows formed in layers 6 and 7 to permit connection of the aluminium bit line to drain regions D.

In Figure 4C, Tr1' is an offset gate transistor, whilst Tr2 is an enhancement transistor.

Figure 4D is a cross-sectional view similar to that of Figure 4C but relating to Figure 4B. In Figure 4D the layer 6 and the bit line are not shown.

As will be understood from Figures 4C and 4D, in this embodiment of the present invention the offset gate transistor Tr1' is such that the polysilicon gate thereof (gate Gp, forming part of word line $W_j$) is isolated or offset from both the source S of transistor Tr1' and the common drain D of transistors Tr1' and Tr2. That is, the gate G' of transistor Tr1' does not extend over either source S or drain D.

In contrast, in the enhancement transistor Tr2, the gate Gp (word line $W_i$) extends over both source S of transistor Tr2 and the common drain D.

An offset gate transistor Tr1' can be formed by appropriate masking in the course of manufacture of the ROM. For example, when the source and drain regions of an offset gate transistor are formed by diffusion, the use of a mask as illustrated at m in Figure 4A (solid line) or in Figure 4B (broken line) for the diffusion will ensure that the diffusion regions constituting the source and drain are spaced sufficiently that they do not extend up to (beneath) the gate electrode Gp (word line $W_j$).

Although in the illustrated embodiment of the present invention both source and drain regions are offset from the gate (Gp) of the offset gate transistor, it is alternatively possible to employ offset gate transistors in which only one or other of the source and drain regions is offset from the gate (i.e. in which the gate extends over one of the source and drain regions).

In a ROM in accordance with the illustrated embodiment of the present invention, when one word line $W_i$ (connected to the gate of one transistor Tr1 of a memory cell) is selected, i.e. is set at "H" level , and the word line $W_j$ (connected to the gate of transistor Tr2) is not selected, i.e. is set at "L" level, if the transistor Tr1 corresponding to the selected word line and the bit line $B_i$ is an offset gate transistor that transistor is in the OFF condition and the potential of the bit line to which the transistors Tr1 and Tr2 are connected is maintained at high level.

In the case in which the transistor Tr1 is an enhancement transistor (having a structure as shown for Tr2 in Figure 4C), when the word line $W_i$ and the bit line $B_i$ are selected the transistor Tr1 becomes conductive and allows current to flow to ground. Thus, the potential of the bit line becomes "L" level.

-10-

According to the embodiment of the present invention explained above, the ROM can be regarded as comprising a plurality of memory cells each comprising a transistor the drain of which is commonly connected to one bit line with the drain of a transistor in an adjacent memory cell, the gate electrode of which is connected to a word line, and the source of which is grounded. User designated data is set in the memory by providing either an offset gate transistor or an enhancement transistor as appropriate in each memory cell.

By the use of such an embodiment of the present invention, lead time can be reduced. Further the provision of a common drain for two adjacent transistors provides for a significant improvement in integration density. For example, in the illustrated embodiment of the present invention, the pattern area required for forming such a memory cell arrangement is $21\mu$ x $9\mu$ , which is about 75% (21/28 x 100) of the pattern area required in the previously proposed mask ROM described above. In other words, the illustrated embodiemnt of the present invention offers an improvement of about 25% in integration density.

An embodiment of the present invention provides a read only memory comprising:-
         a plurality of bit lines;
         a plurality of word lines;
         a plurality of memory cells each of which comprises an offset gate transistor or an enhancement transistor, each of said memory cells being connected to one of said plurality  of bit lines and word lines ; and
         a pair of transistors, belonging to adjacent memory cells, being electrically connected to a bit line via common connection means.

-11-

CLAIMS

1.    A read only memory, comprising:-
a plurality of bit lines,
a plurality of word lines, and
a plurality of memory cells, each comprising a
transistor connected to a respective one of the plurality
of word lines and arranged for establishing a read output
level, in accordance with data set in the memory cell,
on a respective one of the bit lines,
          characterised in that the said transistor of a
memory cell is either an offset gate transistor or an
enhancement transistor, in accordance with
data set in the memory cell, and the said transistor is
connected to the respective one of the bit lines together
with a transistor of an adjacent memory cell via common
connection means.

2.    A memory as claimed in claim 1, characterised in
that such an offset gate transistor, when provided in a
memory cell in accordance with data set in the memory cell,
has a structure wherein the gate of the transistor is
offset from both source and drain regions of the
transistor.

3.    A memory as claimed in claim 1, characterised
in that such an offset gate transistor, when provided
in a memory cell in accordance with data set in the
memory cell, has a structure wherein the gate of the
transistor is offset from one or other of the source
and drain regions of the transistor.

4.    A memory as claimed in claim 1, 2 or 3,
characterised in that the said transistor of a memory
cell and the transistor of the adjacent memory cell have a common drain region.

5.      A memory as claimed in claim 4, characterised in that the common connection means, via which the said transistor of a memory cell and the transistor of the adjacent memory cell are connected to a respective one of the bit lines, comprise an electrode connection window through which the respective one of the bit lines is connected to the common drain region of the said transistor and the transistor of the adjacent memory cell.

FIG. 1A

Bi                    Bj

OUTPUT            OUTPUT

Wi    $Q_1$         $Q_1$

Wj    $Q_2$         $Q_2$

## FIG. 1B

Bi                    Bj

OUTPUT            OUTPUT

Wi    $Tr_1$        $Tr_1$

Wj    $Tr_2$        $Tr_2$

## FIG. 3B

0069493

$B_1$    $B_2$    $B_3$

→A′

$Q_1$                                    Wi

N

N                                        Wj

$Q_2$

→A

## FIG. 2A

Wj            $B_1$   Wi        7      6

$Q_2$                $Q_1$

n+          n+        n+        n+          n+

P

3  5  2  N  4  N  2  5  3        1

## FIG. 2B

FIG. 3A

S     B₁     B₂

Wi

D

Cp

Wj

m

S

→ B'

→ B

Cp

## FIG. 4A

7    B₁    $\frac{(Gp)}{Wj}$    $\frac{(Gp)}{Wi}$    6

n⁺    n⁺    n⁺    n⁺

Tr₁'    Tr₂    P

D   Cp   5   S     5   Cp   D   5    S    1

## FIG. 4C

FIG. 4B

FIG. 4D